Europäisches Patentamt

European Patent Office

Office européen des brevets

(11) Publication number: **0 115 949**
**B1**

# (12) EUROPEAN PATENT SPECIFICATION

(45) Date of publication of patent specification: **30.03.88**

(21) Application number: **84300529.9**

(22) Date of filing: **27.01.84**

(51) Int. Cl.⁴: **H 03 F 3/50, H 03 F 1/30**

(54) **High impedance buffer.**

(30) Priority: **28.01.83 JP 9989/83 u**

(43) Date of publication of application:
**15.08.84 Bulletin 84/33**

(45) Publication of the grant of the patent:
**30.03.88 Bulletin 88/13**

(84) Designated Contracting States:
**DE FR GB**

(56) References cited:
**DE-A-3 037 528**
**FR-A-1 461 683**
**FR-A-1 585 072**
**GB-A-1 059 112**
**US-A-2 955 257**
**US-A-3 436 672**
**US-A-3 517 324**

(73) Proprietor: **SONY CORPORATION**
**7-35 Kitashinagawa 6-Chome Shinagawa-ku**
**Tokyo 141 (JP)**

(72) Inventor: **Ishikawa, Fumio**
**489-2 Tsumada**
**Atsugi-shi Kanagawa-ken (JP)**
Inventor: **Tanaka, Kuninobu**
**1286 Tomuro**
**Atsugi-shi Kanagawa-ken (JP)**

(74) Representative: **Ayers, Martyn Lewis Stanley**
**et al**
**J.A. KEMP & CO. 14 South Square Gray's Inn**
**London, WC1R 5EU (GB)**

Courier Press, Leamington Spa, England.

## Description

The present invention relates generally to buffer circuits and more particularly relates to a buffer circuit having a high input impedance.

Generally, in a sample and hold circuit which intermittently samples a voltage signal to be processed and holds the sampled voltage on a capacitor, this hold voltage on the capacitor is delivered to a next circuit stage. The input impedance of the next stage should be as high as possible as if it is low, charge is leaked from the capacitor and thus, the sample and hold voltage falls, introducing error.

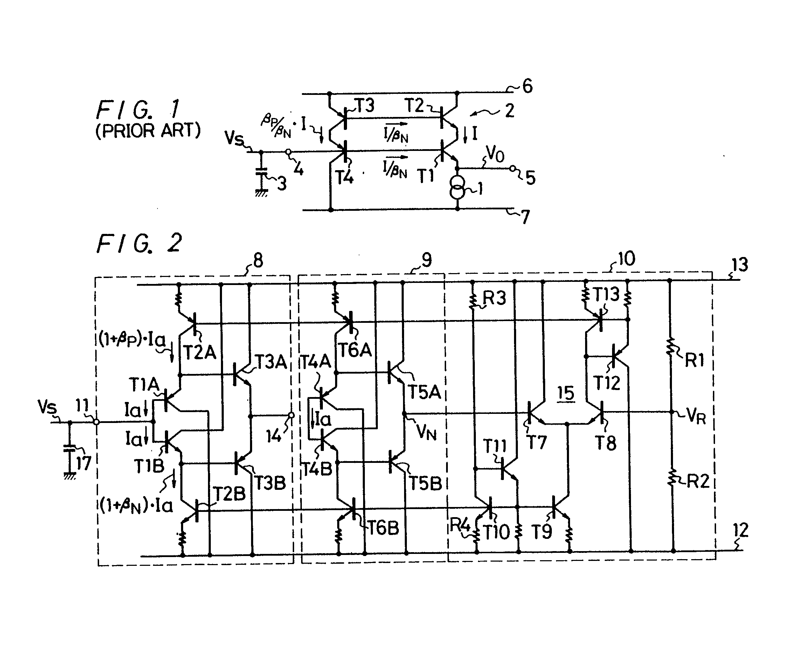

To solve this problem, a circuit which employs complementary bipolar transistors has been proposed as shown in Fig. 1. As seen in Fig. 1, this conventional circuit includes a main transistor T1 such as an NPN transistor which is connected in an emitter-follower configuration. The emitter thereof is connected to a constant current source 1 and the collector thereof is connected to a second transistor T2 such as an NPN transistor which forms a feedback circuit 2. To the base of the main transistor T1 is connected an input terminal 4 to which a sampled voltage from a sampling and holding capacitor 3 is applied. Also, an output terminal 5 is connected to the emitter of the main transistor T1.

The feedback circuit 2 includes third and fourth transistors T3 and T4 connected in series between power source lines 6 and 7, each of the transistors T3 and T4 being formed of the PNP transistor type. The bases of the second and third transistors T2 and T3 are connected to each other, while the bases of the fourth transistor T4 and the main transistor T1 are connected to each other.

With the circuit constructed as shown in Fig. 1, it is assumed that the current amplification factors $h_{fe}$ of the PNP and NPN transistors are taken as $\beta_p$ and $B_N$. In the feedback circuit 2, when a current I is derived from the emitter of the transistor T2, its base current becomes

$$\frac{I}{\beta_N}$$

which is derived from the base of the transistor T3. Accordingly, the collector current of the transistor T3 becomes I.

$$\frac{\beta_p}{\beta_N}$$

which then flows in the emitter of the transistor T4. Therefore, the base current of the transistor T4 becomes I.

$$\frac{\beta_p}{\beta_N} \times \frac{1}{\beta_p} = \frac{I}{\beta_N}$$

which then flows in the base of the main transistor T1 as a feedback current.

When this feedback current flows in the base of the main transistor T1, the emitter current of the transistor T1 becomes

$$\frac{I}{\beta_N} \times \beta_N = I.$$

Thus, the current which flows from the emitter of the transistor T2 to the collector of the main transistor T1 becomes equal so that the circuit is placed into the stable state. This stable state is determined by the constants of the main transistor T1 and the transistors T2 to T4 in the feedback circuit 2 so that when the transistor T1 and the transistors T2 to T4 are formed on an integrated circuit (IC), the current I is determined.

Under this stable state, when the sampled voltage $V_s$ of the capacitor 3 is applied to the base of the main transistor T1, the emitter current I thereof changes in response thereto. This change is positively fed back through the loop of the feedback circuit 2 from the base current

$$\frac{I}{\beta_N}$$

of the transistor T2−>the collector current of the transistor T3−> the base current of the transistor T4−> the emitter current of the main transistor T1 so that the circuit is placed into a new stable state. Thus, the voltage at the emitter of the transistor T1, that is the output voltage $V_0$ becomes a voltage which is lower by the base emitter voltage $V_{BE}$ of the transistor T1 than the input voltage $V_s$ so that the output voltage $V_0$ fluctuates in response to the input voltage $V_s$ and that thus the circuitry constructed as shown in Fig. 1 is operated as the buffer circuit. In addition, when the above circuit is operated as a buffer circuit, it is not necessary to derive the base current from the input terminal 4 (namely, the sampling and holding capacitor 3 at the preceding stage) so as to operate the main transistor T1. Such base current is, however, supplied thereto from the feedback circuit 2.

Therefore, according to the circuit construction shown in Fig. 1, without deriving the current from the input terminal 4, an output voltage $V_0$ can be obtained which changes in accordance with the input voltage $V_s$. In other words, a buffer circuit having sufficiently high input impedance can be realised.

However, in the circuit constructed as shown in Fig. 1, since the correcting current which is supplied to the base of the main transistor T1 is fed back from the feedback circuit 2 on the basis of the collector current of the main transistor T1 (namely, the emitter current of the transistor T2), when the level of the input voltage $V_s$ is changed at high speed, there is then a risk that an undesirable unstable operation such as a so-called ringing or the like may occur on the basis of the delay in the operation of the feedback circuit 2.

Moreover, when the input voltage $V_S$ changes to a considerably larger amplitude at high speed, there is the disadvantage that the waveform of the output voltage $V_0$ changes between the leading edge and the trailing edge. In this connection, when the input voltage $V_S$ is raised at high speed to a large amplitude, the emitter current of the main transistor T1 is rapidly increased so that the output voltage $V_0$ rises without delay. On the other hand, when the input voltage $V_S$ falls at high speed by a large amount the stray capacity at the emitter of the main transistor T1 has to be discharged by the current source I, so even though the main transistor T1 is turned off instantaneously, there is a significant delay in the output voltage $V_0$ falling.

Although an FET (field effect transistor) could be used in a circuit for buffering a large amplitude input voltage, forming FET's and bipolar transistors on the same IC causes problems.

FR—A—1461683 discloses a circuit in accordance with the precharacterising part of claim 1.

It is an object of the present invention to provide an improved buffer circuit.

According to the present invention, there is provided a high input impedance circuit comprising a buffer circuit having first and second pairs of NPN and PNP transistors, bases of said first pair of NPN and PNP transistors being connected to each other, emitters of said second pair of NPN and PNP transistors being connected to each other, emitters of said first pair of PNP and NPN transistors being connected respectively to the bases of said second pair of NPN and PNP transistors and first and second constant current circuits which are respectively connected to said emitters of said first pair of PNP and NPN transistors; characterised in that first and second such buffer circuits are provided, the first buffer circuit being a main buffer circuit section to the bases of the first pair of transistors of which, in use, an input signal to be buffered is applied and the second buffer circuit section being a dummy circuit and means for deriving a feedback signal from the dummy circuit section and applying it to the dummy circuit section and to the main buffer circuit section so as to make the output of the dummy circuit section equal to a predetermined value, the feedback deriving means comprising first and second constant current source circuits for driving said first and second constant current circuits of said first and second buffer circuits respectively and a control circuit for controlling the value of the current of at least one of said first and second constant current source circuits.

The above and other features and advantages of the present invention will become apparent from the following description taken in conjunction with the accompanying drawings through which the like references designate the same elements and parts. In the drawings:—

Figure 1 is a connection diagram showing a conventional buffer circuit; and

Figure 2 is a connection diagram showing an embodiment of a buffer circuit according to the present invention.

In Figure 2, reference numeral 8 designates a main buffer circuit section, 9 a dummy circuit section and 10 a feedback circuit section, respectively.

The main buffer circuit section 8 includes a pair of input side transistors T1A and T1B formed of PNP and NPN transistors which are connected complementary to each other. The bases thereof are connected directly to each other and then connected to an input terminal 11. The collectors thereof are respectively connected to negative and positive power source lines 12 and 13, while the emitters thereof are respectively connected through constant current source transistors T2A and T2B formed of PNP and NPN transistors to the positive and negative power source lines 13 and 12. And, the outputs are supplied to bases of output side transistors T3A and T3B from the emitters of the input side transistors T1A and T1B. Thus, the input side transistors T1A and T1B are connected in an emitter-follower circuit configuration.

The output side transistors T3A and T3B are formed of NPN and PNP transistors, both being connected complementary to each other. The emitters thereof are connected commonly to an output terminal 14, while the collectors thereof are respectively connected to the positive and negative power source lines 13 and 12.

The dummy circuit section 9 is constructed in the same way and using the same components as the main buffer circuit of section 8 and includes input side transistors T4A and T4B, output side transistors T5A and T5B and constant current source transistors T6A and T6B.

The feedback circuit section 10 includes a pair of NPN transistors T7 and T8 which constitute a differential amplifying circuit 15. To the base of one transistor T7 is supplied the output which is derived from the emitters of the output side transistors T5A and T5B in the dummy circuit section 9. To the common connection point of the emitters of the transistors T7 and T8 is connected an NPN transistor T9 serving as a constant current source the base of which is connected to the base of a constant current source driving transistor T10 and the emitter of a transistor T11.

To the base of the other transistor T8 is supplied a reference voltage $V_R$ obtained at the connection point of voltage-dividing resistors R1 and R2 connected in series between the positive and negative power source lines 13 and 12. Accordingly, the transistors T7 and T8 compare the output voltage $V_N$ from the dummy circuit section 9 with the reference voltage $V_R$ which is determined by the resistance values of the resistors R1 and R2 to thereby supply a current of a value corresponding to a difference between voltages $V_N$ and $V_R$ to constant current source driving transistors T12 and T13 from the transistor T8.

The driving transistors T10 and T11 are connected through resistors R3 and R4 to the positive and negative power source lines 13 and 12, whereby a constant current which is determined by the resistance values of the resistors R3 and R4 flows from the transistors T7 and T8 into the transistor T9. The base of the driving transistor T10 is connected to the bases of the constant current source transistor T2B in the main buffer circuit section 8 and the constant current source transistor T6B in the dummy circuit section 9 so that the value of the current supplied to the input side transistors T1B and T4B is made coincident with a current value supplied to the constant current source transistor T9 in the feedback circuit section 10.

On the other hand, the emitter and base of the other constant current source driving transistors T12 and T13 are connected to the bases of the constant current source transistor T2A in the main buffer circuit section 8 and the constant current source transistor T6A in the dummy circuit section 9 so that a value of a current flowing into the input side transistors T2A and T6A is controlled by a difference output derived from the differential amplifying circuit 15 in the feedback circuit section 10 so as to reduce this difference output to zero.

With the circuit construction as described above, the dc bias conditions of respective portions in the main buffer circuit section 8 are determined by the resistance values of the resistors R1, R2 and R3, R4 in the feedback circuit section 10. More specifically, since the dummy circuit section 9 is constructed identically to the main buffer circuit section 8, currents of the same value flow through the corresponding portions. The value of the current flowing through the constant current source transistor T6B in the dummy circuit section 9 (accordingly, the constant current source transistor T2B in the main buffer circuit section 8) is determined by the resistance values of the resistors R3 and R4 connected to the driving transistors T10 and T11. Meanwhile, the value of the current flowing through the constant current source transistor T6A in the dummy circuit section 9 (accordingly, the constant current source transistor T2A in the main buffer circuit section 8) is determined by the resistance values of the resistors R1 and R2 which are connected to the base of one transistor T8 in the differential amplifying circuit 15. The reason is that the constant current source transistor T6A in the dummy circuit section 9 is controlled by the output from the driving transistors T12 and T13 so as to make the output voltage $V_N$ from the emitters of the output side transistors T5A and T5B in the dummy circuit section 9 equal to the reference voltage $V_R$.

When the feedback system, established by feeding the output voltage $V_N$ of the dummy circuit section 9 back to the constant current source transistor T6A through the differential amplifying circuit 15, reaches the stable state as described above, a current Ia derived from the emitter of the input side transistor T4A to the base thereof, is supplied through the base of the input side transistor T4B to the emitter thereof. This operation condition can be established for the main buffer circuit section 8 of the same construction as the dummy circuit section 9. That is, in the stable state the output of the emitters of the output side transistors T3A and T3B is fed back to the constant current source transistor T2A through the differential amplifying circuit 15 and is equivalently established in the main buffer circuit section 9.

Consequently, in the main buffer circuit section 8, the current delivered from the emitter of the transistor T1A to the base thereof becomes Ia and the current delivered from the base of the transistor T1B to the emitter thereof also becomes Ia. In other words, this means that it is not necessary to take in any current from an external circuit connected to the input terminal 11 (for example, a capacitor 17 for sampling and holding) so as to drive the main buffer circuit section 8.

Under the above biasing conditions, the input voltage $V_S$ applied to the input terminal 11 is transmitted through the base-emitter path of the input side PNP transistor T1A and the base-emitter path of the output side NPN transistor T3A to the output terminal 14. The input voltage $V_S$ is also transmitted through the base-emitter path of the input side NPN transistor T1B and the base-emitter path of the output side PNP transistor T3B to the output terminal 14. Accordingly, in one transmission path, the potential is temporarily raised by the base-emitter voltage of the input side transistor T1A (of the PNP transistor) and this potential is lowered by the base-emitter voltage of the output side transistor T3A (of the NPN transistor), while in the other transmission path, the potential is lowered temporarily by the base-emitter voltage of the input side transistor T1B (of the NPN transistor) and this potential is raised by the base-emitter voltage of the output side transistor T3B (of the PNP transistor).

If the above circuit is formed on the same IC, the base-emitter voltages of the transistors T1A and T3B, being PNP transistors, will be substantially equal to each other and the base-emitter voltages of the transistors T1B and T3A, each transistor being an NPN transistor, becomes substantially equal to each other. Therefore, in both of the transmission paths, the relation of the potential at the output terminal 14 relative to the potential at the input terminal 11 becomes equal to each other with the result that as the input voltage $V_S$ is changed, the output voltage $V_0$ is changed in correspondence thereto. Even when the voltage in the transmission path for the output signal is changed, the dc bias condition in the dummy circuit section 9 is never changed so that the current value which is fed back to the constant current source transistor T2A in the main buffer circuit section 8 is never changed. As a result, the input side transistors T1A and T1B in the main buffer circuit section 8 maintain the above state under which the transistors T1A and T1B do not take any significant current from the external circuit by way of the input terminal 11.

In addition to such operation, even if the current amplification factor $h_{fe}$ of the transistor is scattered at each substrate when the circuit construction shown in Fig. 2 is formed on a number of IC substrates, the current which is fed back to the constant current source transistor T6A (accordingly, the constant current source transistor T2A in the main buffer circuit section 8) through the differential amplifying circuit 15 by the output from the dummy circuit section 9 is changed in correspondence with the above scattering to thereby establish the stable state under which the output voltage $V_N$ from the dummy circuit section 9 is coincident with the reference voltage $V_R$. Thus the scattering of the current amplification factor $h_{fe}$ is corrected.

As described above, according to the circuit of the present invention constructed as shown in Fig. 2, without taking in any significant current to the input terminal 11 from the external circuit, the input voltage $V_S$ can be transmitted to the output terminal 14, thus realising the buffer circuit having a considerably large input impedance. Also, in the present invention, the complementary circuits are constructed so that even when the input voltage $V_S$ is changed over the range from the positive to the negative, the above circuits can be operated in the same manner. Therefore, it is possible to transmit the signal of high speed and large amplitude.

As set forth above, a dummy circuit having the same circuit construction as the main buffer circuit, including the complementary input side transistors, gives an output which is compared with the reference voltage by the differential amplifying circuit to provide the correcting feedback signal for the constant current sources of the dummy circuit and the main buffer circuit. Therefore, even if the current amplification factors of the transistors are scattered, such scattered current amplification factors can be corrected so that the buffer circuit which always has a high input impedance and which can transmit the input signal of high speed and large amplitude can be realized by using the bipolar transistors.

## Claims

1. A high input impedance circuit comprising a buffer circuit (8) having first (T1A, T1B) and second (T3A, T3B) pairs of NPN and PNP transistors, bases of said first pair of NPN and PNP transistors (T1A, T1B) being connected to each other, emitters of said second pair of NPN and PNP transistors (T3A, T3B) being connected to each other, emitters of said first pair (T1A, T1B) of PNP and NPN transistors being connected respectively to the bases of said second pair of NPN and PNP transistors (T3A, T3B), collectors of the first and second pairs of NPN and PNP transistors being connected to the supply voltage terminals (12, 13) respectively, and first and second constant current circuits (T2A, T2B) which are respectively connected between said emitters of said first pair of PNP and NPN transistors (T1A, T1B);

and the supply voltage source, characterised in that first and second such buffer circuits (8, 9) are provided, the first buffer circuit (8) being a main buffer circuit section to the bases of the first pair of transistors (T1A, T1B) of which, in use, an input signal to be buffered is applied and the second buffer circuit section (9) being a dummy circuit and means (10) for deriving a feedback signal from the dummy circuit section (9) and applying it to the dummy circuit section (9) and to the main buffer circuit section (8) so as to make the output of the dummy circuit (9) section equal to a predetermined value, the feedback deriving means (10) comprising first (T12, T13) and second (T9, T10) constant current source circuits for driving said first (T2A, T6A) and second (T2B, T6B) constant current circuits of said first and second buffer circuits (8, 9) respectively and a control circuit (15) for controlling the value of the current of at least one of said first and second constant current source circuits (T12 and T13; T9 and T10).

2. A high input impedance circuit according to claim 1, in which said control circuit (15) includes a differential amplifier (T7, T8), first and second input terminals of said differential amplifier being connected to the emitters of said second pair (T5A, T5B) of NPN and PNP transistors of said second buffer circuit (9) and a terminal having a predetermined voltage potential (VR) respectively, an output terminal of said differential amplifier being connected to at least one of said first (T12, T13) and second (T9, T10) constant current source circuits.

3. A high input impedance circuit according to claim 2, further comprising input (11) and output (12) terminals which are respectively connected to the bases of said first pair (T1A, T1B) of PNP and NPN transistors and the emitters of said second pair (T3A, T3B) of PNP and NPN transistors of said first buffer circuit, and a capacitor (17) which is connected across said input terminal (11) and a common terminal.

## Patentansprüche

1. Schaltung mit hoher Eingangsimpedanz, mit einer Pufferschaltung (8), die ein erstes (T1A, T1B) und ein zweites (T3A, T3B) Paar von npn- und pnp-Transistoren aufweist, wobei die Basen des ersten Paares von npn- und pnp-Transistoren (T1A, T1B) miteinander verbunden sind, die Emitter des zweiten Paares von npn- und pnp-Transistoren (T3A, T3B) miteinander verbunden sind, die Emitter des ersten Paares (T1A, T1B) der pnp- und npn-Transistoren jeweils mit einer der Basen des zweiten Paares von npn- und pnp-Transistoren (T3A, T3B) verbunden sind und die Kollektoren des ersten Paares und des zweiten Paares von npn- und pnp-Transistoren jeweils mit Versorgungsspannungsanschlüssen (12, 13) verbunden sind, und eine erste und eine zweite Konstantstromschaltung (T2A, T2B) aufweist, welche jeweils zwischen die Emitter des ersten Paares von pnp- und npn-Transistoren (T1A, T1B) und

die Versorgungsspannungsquelle geschaltet sind, dadurch gekennzeichnet, daß eine erste und eine zweite derartige Pufferschaltung (8, 9) vorgesehen sind, wobei die erste Pufferschaltung (8) ein Hauptpufferschaltungsabschnitt für die Basen des ersten Paares von Transistoren (T1A, T1B) ist, von denen im Betrieb ein zu pufferndes Eingangssignal zugeführt ist, und der zweite Pufferschaltungsabschnitt (9) eine Hilfsschaltung ist, und daß eine Einrichtung (10) ein Rückkopplungssignal von dem Hilfsschaltungsabschnitt ableitet und dem Hilfsschaltungsabschnitt (9) und dem Hauptpufferschaltungsabschnitt (8) zuführt, um so das Ausgangssignal des Hilfsschaltungsabschnitts (9) gleich einem vorbestimmten Wert zu machen, wobei die Einrichtung (10) zum Ableiten des Rückkopplungssignals erste (T12, T13) und zweite (T9, T10) Konstantstromquellenschaltungen zum Ansteuern der ersten (T2A, T6A) und der zweiten (T2B, T6B) Konstantstromschaltungen der ersten bzw. der zweiten Pufferschaltung (8, 9) und einer Steuerschaltung (15) aufweist zum Steuern des Werts des Stroms zumindest einer der ersten und zweiten Konstantstromquellenschaltungen (T12, T13; T9, T10).

2. Schaltung mit hoher Eingangsimpedanz nach Anspruch 1, bei der die Steuerschaltung (15) einen Differenzverstärker (T7, T8) enthält, wobei erster und zweiter Eingangsanschluß des Differenzverstärkers mit den Emittern des zweiten Paares (T5A, T5B) der npn- und pnp-Transistoren der zweiten Pufferschaltung (9) bzw. einem Anschluß auf einem vorbestimmten Spannungspotential (VR) verbunden sind und ein Ausgangsanschluß des Differenzverstärkers mit mindestens einer von erster (T12, T13) und zweiter (T9, T10) Konstantstromquellenschaltung verbunden ist.

3. Schaltung mit hoher Eingangsimpedanz nach Anspruch 2, die desweiteren Eingangs- und Ausgangsanschlüsse (11, 14), die mit den Basen des ersten Paares (T1A, T1B) von pnp- und npn-Transistoren bzw. den Emittern des zweiten Paares (T3A, T3B) von pnp- und npn-Transistoren der ersten Pufferschaltung verbunden sind, und einen Kondensator (17) aufweist, der über den Eingangsanschluß (11) und einen Masseanschluß geschaltet ist.

## Revendications

1. Circuit à haute impédance d'entrée comprenant un circuit tampon (8) avec une première (T1A, T1B) et une seconde (T3A, T3B) paires de transistors NPN et PNP, les bases de ladite première paire de transistors NPN et PNP (T1A, T1B) étant connectées entre elles, les émetteurs de ladite seconde paire de transistors NPN et PNP (T3A, T3B) étant connectés entre eux, les émetteurs de ladite première paire (T1A, T1B) de transistors PNP et NPN étant connectés respectivement aux bases de ladite seconde paire de transistors NPN et PNP (T3A, T3B), les collecteurs de la première et la seconde paire de transistors NPN et PNP étant connectés aux bornes de la tension d'alimentation (12, 13) respectivement, et un premier et un second circuit à courant constant (T2A, T2B) qui sont connectés respectivement entre lesdits émetteurs de ladite première paire de transistors PNP et NPN (T1A, T1B) et à la tension d'alimentation, caractérisé en ce qu'un premier et un second circuit tampon (8, 9) sont prévus, le premier circuit tampon (8) étant une section de circuit tampon principale aux bases de la première paire de transistors (T1A, T1B) auxquelles, en utilisation, un signal d'entrée à enregistrer est appliqué et la seconde section de circuit tampon (9) étant un faux circuit et un dispositif (10) destiné à dériver un signal de réaction de la section de faux circuit (9) et l'appliquant à la section de faux circuit (9) et à la section de circuit tampon principale (8) de manière que la sortie de la section de faux circuit (9) soit égale à une valeur prédéterminée, le dispositif de dérivation de réaction (10) comportant un premier (T12, T13) et un second (T9, T10) circuit de source de courant constant destinés à attaquer ledit premier (T2A, T6A) et ledit second (T2B, T6B) circuits à courant constant du premier et du second circuit tampon (8, 9) respectivement et un circuit de commande (15) commandant l'intensité du courant de l'un au moins dudit premier et dudit second circuit de source de courant constant (T12 et T13, T9 et T10).

2. Circuit à haute impédance d'entrée selon la revendication 1, dans lequel ledit circuit de commande (15) comporte un amplificateur (14) différentiel (T7, T8), une première et une seconde borne d'entrée dudit amplificateur différentiel étant connectées aux émetteurs de ladite seconde paire (T5A, T5B) de transistors NPN et PNP du second circuit tampon (9) et une borne ayant un potentiel de tension prédéterminé (VR) respectivement, une borne de sortie dudit amplificateur différentiel étant connectée à l'un au moins dudit premier (T12, T13) et dudit second (T9, T10) circuit de source à courant constant.

3. Circuit à haute impédance d'entrée selon la revendication 2, comportant en outre une borne d'entrée (11) et une borne de sortie (12) qui sont connectées respectivement aux bases de ladite première paire (T1A, T1B) de transistors PNP et NPN et les émetteurs de ladite seconde paire (T3A, T3B) de transistors PNP et NPN dudit premier circuit tampon et un condensateur (17) qui est connecté entre ladite borne d'entrée (11) et une borne commune.

FIG. 1
(PRIOR ART)

FIG. 2

0 115 949